(19) Europäisches Patentamt / European Patent Office / Office européen des brevets

(11) **EP 4 303 985 A1**

(12) **EUROPEAN PATENT APPLICATION**

(43) Date of publication:
**10.01.2024   Bulletin 2024/02**

(21) Application number: **22306006.2**

(22) Date of filing: **05.07.2022**

(51) International Patent Classification (IPC):
**H01M 10/48** (2006.01)     **H01M 10/42** (2006.01)
**H01M 50/569** (2021.01)     **H01M 10/30** (2006.01)
**H01M 10/34** (2006.01)     **G01R 31/36** (2020.01)

(52) Cooperative Patent Classification (CPC):
**H01M 50/569; G01R 31/36; H01M 10/30;
H01M 10/345; H01M 10/4228; H01M 10/4285;
H01M 10/48;** H01M 2300/0011; H01M 2300/0014

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Saft Groupe
92300 Levallois-Perret (FR)**

(72) Inventor: **NILSSON, Daniel
11233 Stockholm (SE)**

(74) Representative: **Hirsch & Associés
29bis, rue d' Astorg
75008 Paris (FR)**

(54) **APPARATUS AND METHOD FOR DETECTING ELECTROLYTE LEAKAGE IN AN ELECTROCHEMICAL CELL**

(57)   A set-up for detecting an electrolyte leakage from an electrochemical cell, the set-up comprising:
- at least one electrochemical cell (2) containing an electrolyte,
- an electrically conductive component (3) placed with respect to said at least one electrochemical cell so that it is exposed to the electrolyte in case of an electrolyte leakage,
- a complex impedance measuring device (4, 5, 6) configured to measure the complex impedance of the electrically conductive component.

This set-up is useful for distinguishing whether there is an electrolyte leakage or whether any other fully or partially conductive liquid has condensed at the surface of the electrically conductive component.

Fig.1

EP 4 303 985 A1

**Description**

**TECHNICAL FIELD**

The present disclosure relates to devices for detecting an electrolyte leakage that may occur in one or several electrochemical cells. Several electrochemical cells may be part of the same battery or part of different batteries.

**BACKGROUND ART**

An electrochemical cell, also referred to simply as a "cell" in what follows, generally comprises a container in which an electrode plate group impregnated with an electrolyte is inserted. The electrolyte may be a corrosive substance. The walls of the container may be subject to corrosion and eventually leak if they are severely attacked by the electrolyte. Electrolyte leakage may also occur if the container undergoes an external damage.

An electrolyte leakage results in a decrease of the electrolyte level, and thus to an increase of cell internal resistance. As a result, a decrease of cell capacity is observed.

In addition, because of the corrosive nature of the electrolyte, a leakage may cause damage to the equipment located in the vicinity of the leakage. This can be particularly acute in the case where cells are equipped with monitoring equipment or a system which involves a high number of cables connected to the terminals of the cells. Each connection between the monitoring equipment and the electrochemical cell terminals may be affected by an electrolyte leakage.

Finally, as the electrolyte is generally a highly ionic conductive solution, an electrolyte leakage may lead to a short-circuit if it comes into contact with two metal surfaces of different potentials.

It is therefore important to detect an electrolyte leakage from the very first moments of the leakage.

The presence of electrolyte between two metallic parts causes the resistance between these two metallic parts to decrease. Devices measuring the change in the resistance between two metallic parts are known in the art. However, these devices do not allow to differentiate whether the drop in resistance is due to the two metallic parts coming into contact with a fully or partially conductive liquid other than electrolyte, such as tap water, or whether it is due to contact with the electrolyte released during a leakage. Maintenance of the cells includes a periodic cleaning of the outside of the cells and vents with tap water. Tap water may slowly drip from the cells and trigger a false alarm after the cleaning person has left the site. It is therefore important to determine whether the alarm has been triggered by tap water or by the electrolyte.

JP 2012-226866 describes a set-up for detecting the presence of a molten salt released when a container of an electrochemical cell of a group of electrochemical cells leaks. The cell container rests on a mat intended to absorb the molten salt. The mat is made of non-woven glass fibers or made of a porous polymeric film. A tray is placed under the mat and collects the electrolyte. The tray is preferably heated so as to keep the molten salt in a liquid form. A complex impedance measuring device is connected firstly to the wall of one or several cells and secondly to the tray placed under the mat. In the case where the complex impedance measuring device is connected in parallel to each cell of the group of electrochemical cells, it is possible to locate the faulty cell in the group of electrochemical cells. However, this set-up has the following disadvantages:

**[0009]** - The container of the cells must be electrically conductive in order to allow the current to pass during the impedance measurement. It is therefore not possible to use a container made of plastic.

- There is a safety risk for a user because a potential is applied to the container of the cell on which the leakage detection test is to be carried out.
- It is necessary to have an absorbent material under each cell.
- In the case of a plurality of cells, it is necessary to electrically isolate the container of each cell in order to avoid a short-circuit between two neighboring cells. In the absence of an electrically insulating material, it is necessary to leave a space between two neighboring cells so that they do not touch each other.

This document does not describe the possibility of using complex impedance spectroscopy to differentiate between the presence of any fully or partially conductive liquid other than electrolyte and an electrolyte.

It is therefore sought to provide a new set-up or method which makes it possible to overcome one or more of the aforementioned drawbacks.

It is also sought to provide a new method allowing an operator to differentiate between leaked electrolyte and any fully or partially conductive liquid other than electrolyte.

**SUMMARY OF THE INVENTION**

To this end, a first object of the invention is a set-up comprising:

- at least one electrochemical cell containing an electrolyte,
- an electrically conductive component placed with respect to said at least one electrochemical cell so that it is exposed to the electrolyte in case of an electrolyte leakage,
- a complex impedance measuring device configured to measure the complex impedance of the electrically conductive component.

This set-up can be used for detecting an electrolyte leakage from an electrochemical cell.

The invention is based on the finding that the combined knowledge of the real part and the imaginary part of the complex impedance allows to differentiate whether the drop in resistance of the electrically conductive component is due to the presence of water resulting from the condensation of water vapor or to the presence of tap water or to the presence of electrolyte resulting from a cell leakage.

According to one embodiment, the electrically conductive component is placed under the at least one electrochemical cell.

According to one embodiment, the electrically conductive component is a metallic mesh.

According to one embodiment, the electrically conductive component is sized so as to exhibit a resistance of from 300 to 700 ohm.

According to one embodiment, the electrically conductive component is a metallic mesh made of interconnected strands of metal, each metal strand having a width of from 0.5 to 1.5 mm, the distance between the center of two interconnections of strands ranging from 0.5 to 20 mm.

According to one embodiment, the complex impedance measuring device is directly connected to two ends of the electrically conductive component.

According to one embodiment, the electrolyte is an alkaline or an acid electrolyte.

According to one embodiment, the at least one electrochemical cell is a nickel-cadmium or a nickel-metal hydride electrochemical cell.

According to one embodiment, the set-up comprises:

a) one electrochemical cell, the cell being part of a battery, or
b) several electrochemical cells, the electrochemical cells being part of a same battery or part of different batteries.

A second object of the invention is a room or a compartment comprising the set-up previously described, wherein the electrically conductive component is a metallic mesh resting on the floor of the room or the compartment.

A third object of the invention is a method for detecting an electrolyte leakage from at least one electrochemical cell, said method comprising the steps of:

a) providing the set-up previously described,
b) carrying out a calibration step by contacting the electrically conductive component successively with air, with water resulting from the condensation of water vapor of ambient air or with tap water, and with the electrolyte, the percentage of the surface of the electrically conductive component covered by water or by the electrolyte being varied and measuring the complex impedances of the electrically conductive component for each contact in order to obtain a set of calibrated complex impedance spectrums,
c) measuring the complex impedance spectrum of the electrically conductive component,
d) comparing the complex impedance spectrum obtained in step c) with the calibrated complex impedance spectrums so as to determine whether the electrically conductive component is in contact with air or with water resulting from the condensation of water vapor or with tap water or with the electrolyte,
e) repeating steps c) and d) until it is determined in step d) that the electrically conductive component is in contact with electrolyte.

According to one embodiment, step d) comprises the step of comparing the imaginary part of the complex impedance spectrum obtained in step c) with the imaginary part of the calibrated complex impedance spectrums.

According to one embodiment, in step b), the step of contacting the electrically conductive component with tap water or with the electrolyte consists of fully immersing the electrically conductive component with tap water or with the electrolyte.

Embodiments of the invention are described below in more details with reference to the attached drawings.

**BRIEF DESCRIPTION OF THE DRAWINGS**

FIG. 1 is an example of a set-up according to the invention.

FIG. 2 is a top view of an example of a metallic mesh.

FIG. 3 represents the real part and the imaginary part of the impedance spectrum of a bare metallic mesh as a function of the frequency of the applied signal.

FIG. 4 represents the real part of the impedance spectrum of a metallic mesh covered a) with electrolyte over 20% of its surface and b) with tap water over 100% of its surface, as a function of the frequency of the applied signal.

FIG. 5 represents the imaginary part of the impedance spectrum of a metallic mesh covered a) with electrolyte over 20% of its surface and b) with tap water over 100% of its surface, as a function of the frequency of the applied signal.

FIG. 6 represents the real part of the impedance spectrum of the metallic mesh of examples A, B, C and D, as a function of the frequency of the applied signal.

FIG. 7 represents the imaginary part of the impedance spectrum of the metallic mesh of examples A, B, C and D, as a function of the frequency of the applied signal.

## DETAILED DESCRIPTION OF EMBODIMENTS

Description of the set-up:

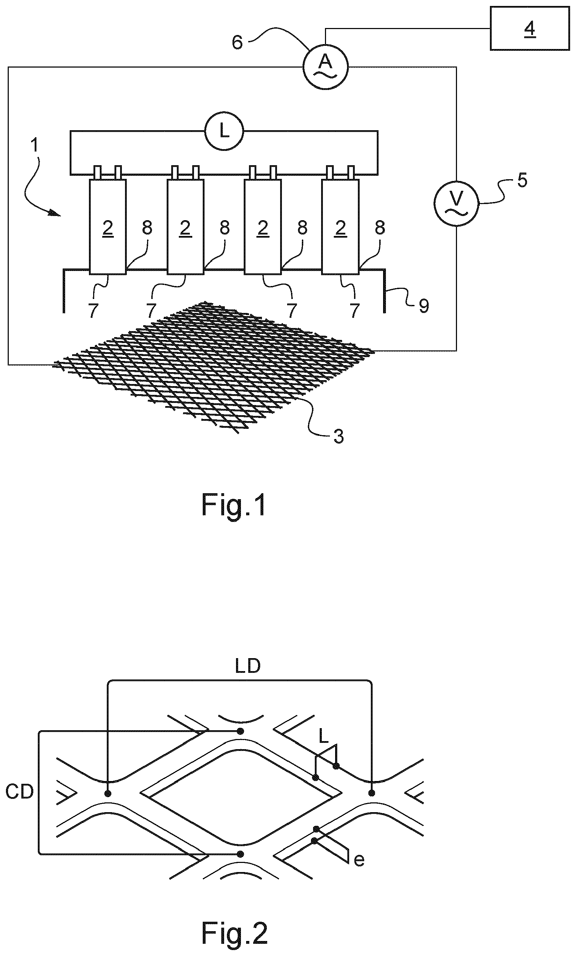

The set-up according to the invention is schematically illustrated in FIG. 1. It comprises:

- a battery 1 comprising several electrochemical cells 2 each containing an electrolyte. The battery may be connected to an electric load L.
- an electrically conductive component 3 placed with respect to the electrochemical cells so that it is exposed to the electrolyte in case of an electrolyte leakage,
- a complex impedance measuring device 4, 5, 6 configured to measure the complex impedance of the electrically conductive component. It is electrically connected to two ends of the electrically conductive component.

FIG. 1 shows a battery comprising several electrochemical cells but it is understood that the battery may comprise only one electrochemical cell. Also, in the following, the term "battery" refers to one or several electrochemical cell(s), also simply referred to as cell(s).

The complex electrochemical impedance may be measured by applying an AC voltage 5 to the electrically conductive component 3 and then measuring the AC current passing through the electrically conductive component via a current measuring device 6. A device 4 then calculates the complex impedance. Alternatively, it is also possible to apply an AC current to the electrically conductive component 3 and to measure the AC voltage between the two ends of the electrically conductive component.

Preferably, the electrically conductive component covers the floor of the room in which the battery is placed. The electrically conductive component is placed under the container 7 of the cells 2 so that any droplet of electrolyte leaking from a container falls by gravity on the electrically conductive component.

As it can be seen in FIG. 1, there is no electric contact between the bottom of the container 7 of the cell(s) and the electrically conductive component 3. This can be achieved by placing the cell containers into holes 8 made in a supporting structure 9. The supporting structure maintains the cells above the electrically conductive component. Any type of supporting structure allowing to maintain a distance between the cells and the electrically conductive component may be used. It is possible not to use a supporting structure and to stick an electrically insulating component to the bottom of the cell containers so that electrical contact between the cells and the electrically conductive component is avoided. Hence, the current generated by the complex impedance measurement does not flow through the electrochemical cells of the battery. The impedance measured by the complex impedance measuring device is only the impedance of the electrically conductive component whether it is in contact or not with a liquid.

The metal of the electrically conductive component is not limited. It may be selected from aluminum, an aluminum alloy, copper, a copper alloy, nickel, a nickel alloy, stainless steel and silicon carbon steel.

The electrically conductive component may be sized so as to exhibit a resistance of from 300 to 700 ohm, preferably from 450 to 550 ohm. Preferably, the resistance is at least 500 ohm. If the resistance is too low the measurement of the complex impedance may not be reliable. Such ranges of resistance may be obtained using a metallic mesh made from one of the cited materials and having an open-worked structure. The resistance of the electrically conductive component may be varied by varying the area and the number of cut-out portions used for creating the open-worked structure. The greater the number of cut-out parts, the greater the resistance. Also, the greater the area of the cut-out parts, the greater the resistance.

The cut-out parts may be obtained by perforating a solid metal sheet. One may also use an expanded metal. An expanded metal is produced by shearing a metal strip in a press equipped with knives. The knives create a series of evenly spaced notches in the strip. By stretching the metal perpendicular to the direction of the cuts, a metallic mesh is created, usually rhombus-shaped, leaving voids surrounded by interconnected metal strands.

FIG. 2 shows a top view of metallic mesh having an open-worked structure. The cut-out parts have a rhombus form. The metal strands delimit the rhombus. The dimensions of the rhombus as well as those of the metal strands are not limited. Typical size ranges are as follows:

- each metal strand may have a width L ranging from 0.10 to 3 mm, preferably from 0.5 to 1.5 mm;
- the distance LD between the center of two interconnections of strands located on the longest diagonal of the rhombus may vary from 0.5 mm to 20 mm, preferably from 1 to 10 mm;
- the distance CD between the center of two interconnections of strands located on the shortest diagonal of the rhombus may vary from 0.2 mm to 15 mm, preferably from 0.5 to 10 mm;
- the thickness "e" of the metal can vary from 25 $\mu$m to 2 mm, preferably from 120 $\mu$m to 1.5 mm, and more preferably from 300 $\mu$m to 1 mm.

The invention can be implemented to detect electrolyte leakage from the container of a single electrochemical cell or from a container of one of the cells of a plurality of electrochemical cells. The electrochemical cell can be of any technology. One advantage of the invention is that the cell container may be made of an electrically insulating material, such as plastics. It can be a vented electrochemical cell or a valve-regulated one. Electrochemical cells having an alkaline-based electrolyte, such as Ni/Cd, Ni/MH, Ni-Zn and Ni-Fe cells are preferred. This type of cells contains an aqueous electrolyte in which one or several hydroxides of an alkali metal are dissolved at a total concentration generally ranging from 1 to 4 M. Lead-acid electrochemical cells may also be envisioned. This type of cells contains an aqueous electrolyte in which sulfuric acid is dissolved at a concentration generally ranging from 1 to 4 M.

The invention can be implemented to detect electrolyte leakage from the container of a monobloc battery, that is, a battery with multiple separate but electrically connected electrochemical cell compartments each of which being designed to house an assembly of electrodes, electrolyte, terminals or interconnections and possibly separators. The electrochemical cells in the monobloc battery can be connected in series or in parallel. The container of a monobloc battery is a parallelepiped container comprising divider walls, each divider wall separating two adjacent electrochemical cells. Preferably the monobloc battery is a Ni/Cd or Ni/MH monobloc battery.

Principle of the method according to the invention:

Electrochemical impedance spectroscopy involves measuring the electrical response of a system when subjected to a sinusoidal current or a sinusoidal voltage. Electrochemical impedance is usually measured by applying an AC voltage to a system and then measuring the current through the system. The AC voltage can be a sinusoidal voltage excitation expressed as a function of time as:

$E_t = E_0 \sin(\omega t)$ where
$E_t$ is the voltage at time t,
Eo is the amplitude of the voltage,
w is the radial frequency in rad/s

The relationship between the radial frequency $\omega$ expressed in rad/s and the frequency f expressed in Hertz is $\omega = 2\pi f$

The response to the AC voltage is an AC current signal expressed as a function of time as:

$I_t = I_0 \sin(\omega t + \varphi)$ where
$I_t$ is the current at time t,
Io is the amplitude of the current,
$\varphi$ is the phase shift

The impedance Z of the system is:

$$Z = \frac{E_t}{I_t} = \frac{E_0 \sin(\omega t)}{I_0 \sin(\omega t + \varphi)} = Z_0 \frac{\sin(\omega t)}{\sin(\omega t + \varphi)} = Z_0(\cos\varphi + j\sin\varphi) = Z_0\cos\varphi + jZ_0\sin\varphi =$$

$$Re(Z) + jIm(Z).$$

The variation of the real part Re(Z) as a function of the frequency of the sinusoidal signal applied and the variation of the imaginary part Im(Z) as a function of the frequency of the sinusoidal signal applied are both plotted.

The impedance spectrum of the electrically conductive component is recorded as a function of the frequency of the applied sinusoidal signal for the following situations:

- the electrically conductive component is bare,
- the electrically conductive component is in contact with a liquid which may be distilled water or tap water or the electrolyte.

An impedance spectrum alone does not allow determining whether the liquid in contact with the electrically conductive component is water (distilled or tap) or electrolyte. The knowledge of the values of the real part and of the imaginary part cannot directly inform an operator about the composition of the liquid. Implementation of the invention requires a prior calibration by plotting the complex impedance spectrums of the electrically conductive component covered to different extents by an electrolyte having a known concentration of salt. The salt concentration is known because it is the composition of the electrolyte used during the preparation of the cell. The calibration may be carried out with an electrically conductive component the percentage of surface covered by the liquid being for example 10%, 20%, 30%, 40%, 50%, 60%, 70%, 80%, 90% and 100%. Calibration is performed with at least two different percentages of coverage. A linearization is then performed between these at least two percentages of coverage.

One thus obtains:

- at a given frequency, a set of real part values corresponding to different percentages of coverage, the electrolyte concentration being known and constant.

| Percentage (%) of the surface of the electrically conductive component covered by the electrolyte | 10 | 20 | ... | 90 | 100 |
|---|---|---|---|---|---|
| Re(Z) | | | | | |

- at a given frequency, a set of imaginary part values corresponding to different percentages of coverage, the electrolyte concentration being known and constant.

| Percentage (%) of the surface of the electrically conductive component covered by the electrolyte | 10 | 20 | ... | 90 | 100 |
|---|---|---|---|---|---|
| Im(Z) | | | | | |

The calibration step may also comprise the step of plotting the complex impedance spectrums of the electrically conductive component covered to different extents by tap water or by distilled water. One thus obtains:

- at a given frequency, a set of real part values corresponding to different percentages of coverage of the electrically conductive component by tap water or by distilled water.
- at a given frequency, a set of imaginary part values corresponding to different percentages of coverage of the electrically conductive component by tap water or by distilled water.

The bare electrically conductive component acts as a pure resistor. Its impedance does not vary as a function of the frequency of the applied signal. Hence, it is not necessary to plot the complex impedance spectrum of the bare electrically conductive component over a range of frequencies. It is sufficient to know the real part of the impedance at a given frequency. The imaginary part is zero whatever the frequency.

Once the calibration step is completed, the actual detection step can begin. The complex impedance spectrum of the electrically conductive component is recorded periodically. For a given frequency, the real part value measured during the detection step is compared to the sets of real part values obtained during the calibration step. Similarly, for a given frequency, the imaginary part value measured during the detection step is compared to the sets of imaginary part values obtained during the calibration step. These comparisons make it possible to determine whether the electrically conductive component is in contact with air or with distilled water or with tap water or with electrolyte.

If the comparison indicates that the electrically conductive component is in contact with air, the detection step is repeated until water or electrolyte is detected. If it is detected that the electrically conductive component is in contact with electrolyte a warning message is sent to the operator. A different warning may be sent to the operator if it is detected that the electrically conductive component is in contact with distilled water or tap water. The invention makes it possible to carry out a real-time detection of an electrolyte leakage.

The usefulness of the method according to the invention will be better understood by making reference to FIGS.

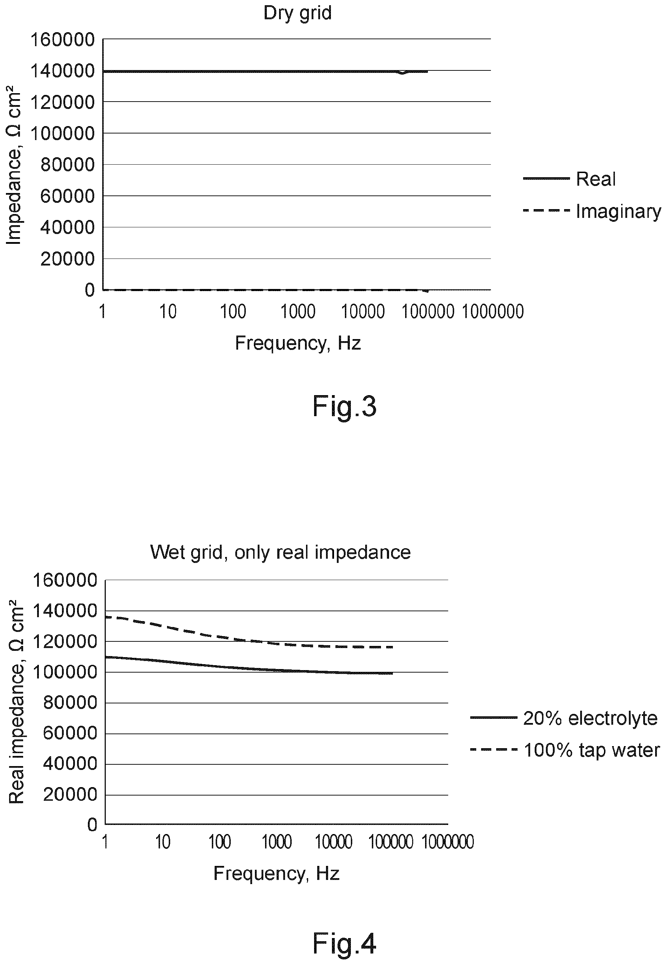

3, 4 and 5. FIG. 3 shows the variations of the real and the imaginary parts of the electrically conductive component for a frequency ranging from 1 Hz to 100,000 Hz when it is not in contact with any liquid. The real part Re(Z) does not vary as a function of the frequency of the applied signal. The electrically conductive component acts as a simple resistor. The imaginary part lm(Z) is zero. The impedance is equal to the resistance of the electrically conductive component.

When an ionic conducting liquid such as tap water or electrolyte covers a portion of the electrically conductive component, the combination of the electrically conductive component and the ionic conducting liquid forms a complex system characterized by a complex impedance comprising a real component Re(Z) and an imaginary component lm(Z). FIG. 4 shows the real part of the impedance spectrum of a metallic mesh covered with a) electrolyte over 20% of its surface and b) tap water over 100% of its surface. The presence of electrolyte in contact with the current conducting component causes the real part of the impedance to decrease. It can be noted that if the electrolyte had covered the electrically conductive component over a smaller area (15%, 10, 5% or even less), the decrease of the real part would have been less significant. There may have been an overlap between the real part in the case of a 100% coverage of the electrically conductive component by water and the real part in the case of less than 20% coverage of the electrically conductive component by electrolyte.

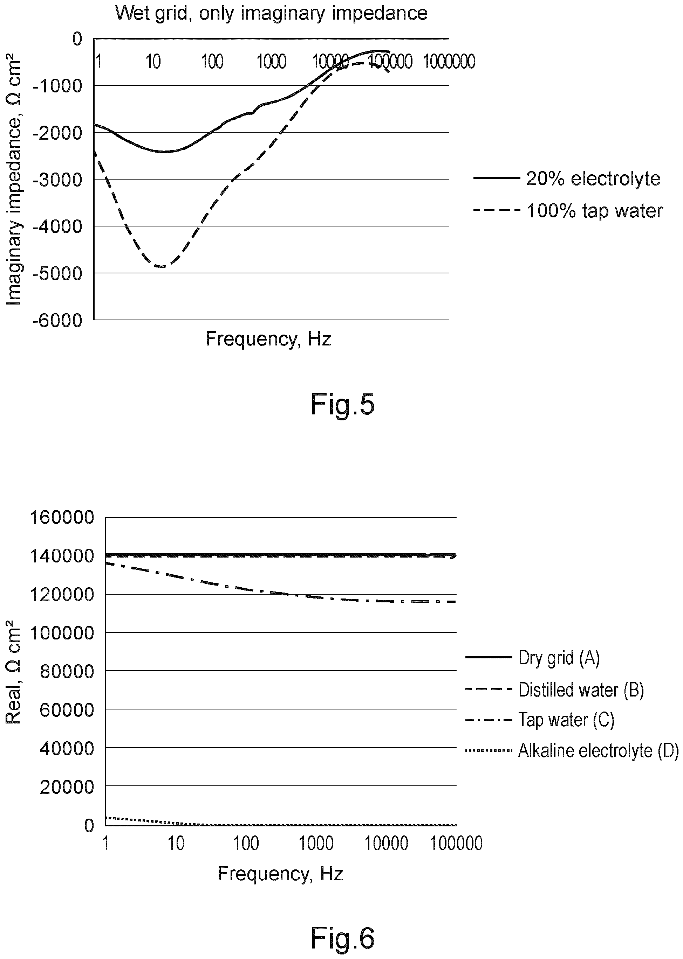

The invention makes it possible to remove the uncertainty about the nature of the liquid in contact with the electrically conductive component by taking advantage of the imaginary part of the complex impedance. The imaginary part of the impedance differs significantly depending on whether the ionic conducting liquid in contact with the electrically conductive component is tap water or electrolyte. This is illustrated in FIG. 5. At about 10 Hz, the absolute value of the imaginary part when the ionic conducting liquid is tap water is twice as high as the absolute value of the imaginary part when the ionic conducting liquid is electrolyte. Knowing the real part and the imaginary part of the complex impedance of the system constituted by the electrically conductive component and the ionic conductive liquid and comparing it with the real part and the imaginary part of the complex impedance determined during the calibration step makes it possible to determine the nature of the liquid and to conclude whether the liquid in contact with the electrically conductive component is electrolyte or not.

**EXAMPLES**

Four identical metallic meshes were provided. One mesh (mesh A) was not contacted with any liquid. Three meshes (B, C, and D) were each covered by a particular liquid. This liquid was distilled water for mesh B, tap water for mesh C and an alkaline electrolyte for mesh D. The complex impedance spectroscopy measurements were run on each of these four meshes. The measurements were carried out using a potentiostat-galvanostat Gamry Interface 5000P™ operated in the potentiostatic mode. The voltage amplitude was 1.5 V. The metallic mesh was an expanded silicon carbon steel having a square shape with a side length of about 30 cm. The strand width was 1 mm. The distance between the center of two interconnections of strands was 3 mm. The range of the swept frequencies was from 1 to 100 000 Hz.

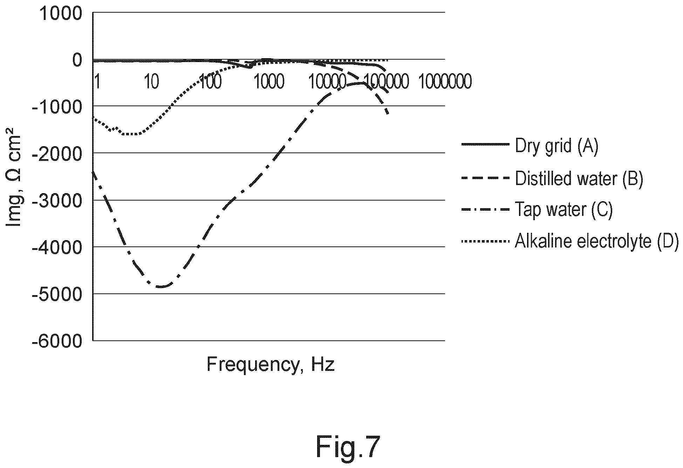

The real part and the imaginary parts were drawn in FIGS. 6 and 7 respectively.

| Mesh | |
|---|---|
| A | Bare metallic mesh |
| B | Metallic mesh immersed in distilled water |
| C | Metallic mesh immersed in tap water |
| D | Metallic mesh immersed in alkaline electrolyte about 1 M |

FIG. 6 shows that the real part of the impedance is constant for meshes A and B thus indicating that these meshes are comparable to pure resistors. The real part of the impedance for mesh C remains high over the whole range of frequencies. The real part of the impedance for mesh D is almost 0 whatever the frequency thus indicating a high ionic conductivity.

FIG. 7 confirms that the meshes A and B are comparable to pure resistors. The absolute value of the imaginary part of meshes C and D first increases as the frequency increases from 1 to 10 Hz and then decreases as the frequency increases from about 10 to about 50000 Hz. It is worth noting that the absolute value of the imaginary part of the impedance for mesh D immersed in the alkaline electrolyte falls to about 0 and remains at 0 for frequencies higher than 1000 Hz. In contrast, the absolute value of the imaginary part of the impedance for meshes B and C starts to increase for frequencies higher than 50000 Hz. This different variation between meshes B, C on one side and mesh D on the other side allows concluding that mesh D is the one covered by the electrolyte.

**Claims**

1. A set-up comprising:

   - at least one electrochemical cell (2) containing an electrolyte,
   - an electrically conductive component (3) placed with respect to said at least one electrochemical cell so that it is exposed to the electrolyte in case of an electrolyte leakage,
   - a complex impedance measuring device (4, 5, 6) configured to measure the complex impedance of the electrically conductive component.

2. The set-up according to claim 1, wherein the electrically conductive component is placed under the at least one electrochemical cell.

3. The set-up according to claim 1 or 2, wherein the electrically conductive component (3) is a metallic mesh.

4. The set-up according to any of claims 1 to 3, wherein the electrically conductive component (3) is sized so as to exhibit a resistance of from 300 to 700 ohm.

5. The setup according to claim 3 or 4, wherein the electrically conductive component (3) is a metallic mesh made of interconnected strands of metal, each metal strand having a width of from 0.5 to 1.5 mm, the distance between the center of two interconnections of strands ranging from 0.5 to 20 mm.

6. The set-up according to any of claims 1 to 5, wherein the complex impedance measuring device (4, 5, 6) is directly connected to two ends of the electrically conductive component (3).

7. The set-up according to any of the preceding claims, wherein the electrolyte is an alkaline or an acid electrolyte.

8. The set-up according to any of the preceding claims, wherein the at least one electrochemical cell is a nickel-cadmium or a nickel-metal hydride electrochemical cell.

9. The set-up according to any of the preceding claims, comprising:

   a) one electrochemical cell (2), the cell being part of a battery (1), or
   b) several electrochemical cells (2), the electrochemical cells being part of a same battery (1) or part of different batteries.

10. A room or a compartment comprising the set-up according to any of the preceding claims, wherein the electrically conductive component (3) is a metallic mesh resting on the floor of the room or the compartment.

11. A method for detecting an electrolyte leakage from at least one electrochemical cell, said method comprising the steps of:

    a) providing the set-up according to any of claims 1 to 9,
    b) carrying out a calibration step by contacting the electrically conductive component (3) successively with air, with water resulting from the condensation of water vapor of ambient air or with tap water and with the electrolyte, the percentage of the surface of the electrically conductive component covered by water or by the electrolyte being varied and by measuring the complex impedances of the electrically conductive component for each contact in order to obtain a set of calibrated complex impedance spectrums,
    c) measuring the complex impedance spectrum of the electrically conductive component,
    d) comparing the complex impedance spectrum obtained in step c) with the calibrated complex impedance spectrums so as to determine whether the electrically conductive component is in contact with air or with water resulting from the condensation of water vapor or with tap water or with the electrolyte,
    e) repeating steps c) and d) until it is determined in step d) that the electrically conductive component is in contact with electrolyte.

12. The method of claim 11, wherein step d) comprises the step of comparing the imaginary part of the complex impedance spectrum obtained in step c) with the imaginary part of the calibrated complex impedance spectrums.

**13.** The method according to any of claims 11 and 12, wherein in step b), the step of contacting the electrically conductive component with tap water or with the electrolyte consists of fully immersing the electrically conductive component with tap water or with the electrolyte.

Fig.1

Fig.2

Dry grid

Fig.3

Wet grid, only real impedance

Fig.4

Fig.5

Fig.6

Fig.7

Europäisches
Patentamt

European
Patent Office

Office européen
des brevets

# EUROPEAN SEARCH REPORT

Application Number

EP 22 30 6006

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2012 226866 A (SUMITOMO ELECTRIC INDUSTRIES) 15 November 2012 (2012-11-15) | 1-10 | INV.<br>H01M10/48 |
| A | * paragraphs [0007] - [0017], [0020] - [0040] *<br>* figures 1-7 * | 11-13 | H01M10/42<br>H01M50/569<br>H01M10/30 |
| A | US 2020/067145 A1 (YAMASHIMA MASAYUKI [JP] ET AL) 27 February 2020 (2020-02-27)<br>* paragraphs [0012] - [0032] * | 1-13 | H01M10/34<br>G01R31/36 |
| A | JP H08 250159 A (NIPPON TELEGRAPH & TELEPHONE) 27 September 1996 (1996-09-27)<br>* abstract * | 1-13 | |
| A | JP 2007 294174 A (MATSUSHITA ELECTRIC IND CO LTD) 8 November 2007 (2007-11-08)<br>* abstract * | 1-13 | |

TECHNICAL FIELDS
SEARCHED      (IPC)

H01M
G01R

The present search report has been drawn up for all claims

| Place of search | Date of completion of the search | Examiner |
|---|---|---|
| Munich | 19 January 2023 | Mercedes González |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 30 6006

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-2023

| Patent document cited in search report | | Publication date | Patent family member(s) | | Publication date |
|---|---|---|---|---|---|
| JP 2012226866 A | | 15-11-2012 | NONE | | |
| US 2020067145 A1 | | 27-02-2020 | CN 110495012 A | | 22-11-2019 |
| | | | EP 3716352 A1 | | 30-09-2020 |
| | | | JP 7092148 B2 | | 28-06-2022 |
| | | | JP WO2019102986 A1 | | 01-10-2020 |
| | | | US 2020067145 A1 | | 27-02-2020 |
| | | | WO 2019102986 A1 | | 31-05-2019 |
| JP H08250159 A | | 27-09-1996 | NONE | | |
| JP 2007294174 A | | 08-11-2007 | JP 5092268 B2 | | 05-12-2012 |
| | | | JP 2007294174 A | | 08-11-2007 |

For more details about this annex : see Official Journal of the European Patent Office, No. 12/82

**EP 4 303 985 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012226866 A